# FASCICULE DE BREVET EUROPEEN

(11) **EP 1 597 604 B1**
(45) Date de publication et mention de la délivrance du brevet: **26.05.2010**
(21) Numéro de dépôt: 04714357.3
(22) Date de dépôt: 25.02.2004
(51) Int. Cl.: G01R 31/12, G01R 31/16

(54) **ANTENNE POUR DETECTER DES DECHARGES PARTIELLES DANS UNE CUVE D'APPAREILLAGE ELECTRIQUE**
ANTENNE ZUR ERMITTLUNG VON TEILENTLADUNGEN IN EINEM GEHAUSE EINES ELEKTRISCHEN GERÄTS
ANTENNA FOR DETECTION OF PARTIAL DISCHARGES IN A CHAMBER OF AN ELECTRICAL INSTRUMENT

(30) Priorité: 27.02.2003 FR 0302388
(43) Date de publication de la demande: 23.11.2005
(73) Titulaire: AREVA T&D SAS, 92084 Paris La Défense Cedex (FR)
(72) Inventeur: RAJA, Kuppuswamy, F-75018 PARIS (FR)
(74) Mandataire: Poulin, Gérard
(86) Numéro de dépôt international: PCT/FR2004/050081
(87) Numéro de publication internationale: WO 2004/079379

(56) Documents cités:
- EP-A- 0 984 289
- EP-A1- 0 699 918
- US-A- 4 942 377
- US-A1- 2002 024 341
- US-B1- 6 323 655

## Description

L'invention concerne un capteur pour détecter des décharges partielles dans une cuve d'appareillage électrique remplie d'un fluide diélectrique, comprenant une antenne sensible aux ondes électromagnétiques générées par ces décharges partielles.

Ces ondes s'étalent en fréquence depuis la gamme des hautes fréquences (HF) jusqu'à la gamme des ultra-hautes fréquences (UHF), les fréquences les plus élevées pouvant atteindre approximativement 2 GHz si le fluide diélectrique est un gaz et approximativement 1,5 GHz si ce fluide est un liquide.

La détection d'impulsions de décharges électriques partielles par la réalisation de mesures dans la gamme fréquences HF et VHF est couramment mise en oeuvre depuis plusieurs années pour des appareillages électriques installés dans une enveloppe remplie d'un fluide diélectrique liquide ou gazeux, mais présente des inconvénients. En effet, des décharges corona ayant lieu dans l'environnement de l'appareillage génèrent des ondes électromagnétiques de forte intensité dans les mêmes gammes de fréquences HF et VHF jusqu'à quasiment 200 MHz, ce qui perturbe significativement les mesures.

Aussi, pour améliorer la qualité des mesures, il est nécessaire de réaliser celles-ci dans la gamme des fréquences UHF de manière à s'affranchir des perturbations dues aux décharges corona. Le brevet US5804972 décrit un dispositif de détection d'impulsions de décharges électriques partielles dans un appareillage électrique blindé isolé au gaz, grâce à une antenne UHF installée dans l'appareillage et dont une électrode est montée au niveau de l'enveloppe de l'appareillage. La fonction de transfert d'une telle antenne est relativement haute et plate dans une large bande de fréquences UHF s'étendant typiquement de 300 MHz à 1,8 GHz.

Il n'est pas prévu dans ce dispositif de pouvoir retirer l'antenne de son logement sans mettre l'appareillage provisoirement hors service, puisqu'un démontage de l'antenne implique une perte d'étanchéité entre le gaz à l'intérieur de l'enveloppe et l'air extérieur.

La possibilité de pouvoir retirer de son logement une telle antenne pour la détection d'impulsions de décharges partielles existe par ailleurs dans le domaine des appareillages électriques tels que des transformateurs placés dans une cuve remplie d'un liquide diélectrique tel que de l'huile.

Un capteur de décharge partielle pouvant être introduit dans une vanne de vidange jusqu'à une ouverture de la cuve est décrit par le document de brevet US 6323655. Un tel capteur comprend une antenne par exemple en forme de spirale, et peut être installé et retiré sans avoir à mettre le transformateur hors exploitation. Il comprend en outre une douille destinée à être accouplée à la vanne de vidange, l'antenne étant montée sur un support pouvant coulisser dans cette douille et dans la vanne de vidange. Ainsi, le capteur peut être utilisé successivement sur plusieurs vannes identiques à différents endroits de la cuve d'un appareillage électrique isolé dans l'huile, sans interrompre l'exploitation de l'appareillage.

Cette antenne a une taille inférieure au diamètre de la vanne de vidange pour lui permettre de passer dans l'alésage de cette vanne. Il est à noter que la fonction de transfert de l'antenne est inversement proportionnelle à la fréquence et varie dans le même sens que le diamètre de la vanne. Or, les vannes couramment utilisées dans les transformateurs dans une cuve à isolation à l'huile possèdent des vannes de diamètres relativement faibles, typiquement inférieurs à 50 mm. le capteur pourra ainsi avoir une fonction de transfert qui reste satisfaisante dans la gamme de fréquences HF et VHF mais qui devient dégradée pour les fréquences UHF. Cette dégradation se traduit par des valeurs trop basses pour fournir un signal d'antenne réellement exploitable, et se traduit aussi par une multitude de pics de résonance qui empêchent d'exploiter correctement tout signal d'antenne.

Si le capteur est équipé d'une antenne en spirale, son adaptation aux ultra-hautes fréquences nécessiterait d'avoir une spirale dont le diamètre serait supérieur aux diamètres des vannes de vidange couramment installées, de sorte qu'il ne serait plus possible de faire passer le capteur dans la vanne.

Le document US-A-2002024341 décrit un capteur pour détecter des décharges dans un appareil d'isolation électrique au moyen d'une antenne placée à l'extérieur de cet appareil.

Le but de l'invention est de remédier à ces inconvénients en proposant un capteur de dimensions relativement faibles et qui présente une fonction de transfert satisfaisante dans le domaine des ultra-hautes fréquences, afin de pouvoir effectuer des mesures précises de décharges partielles en plaçant le capteur dans toute ouverture disponible de la cuve de l'appareillage électrique, comme par exemple dans une vanne de vidange d'une cuve d'un transformateur isolé dans de l'huile.

A cet effet, l'invention a pour objet un capteur pour détecter des décharges partielles dans une cuve d'appareillage électrique remplie d'un fluide diélectrique, comprenant une antenne sensible aux ondes électromagnétiques générées par ces décharges partielles, **caractérisé en ce que** cette antenne est formée par deux électrodes séparées par un résonateur diélectrique. Il est ainsi possible d'effectuer des mesures précises de décharges partielles en ayant un capteur adapté pour pouvoir être introduit notamment dans une vanne de vidange.

Selon un mode de réalisation préféré, la première électrode a une forme de disque, la seconde électrode a une forme de tronc de cône à extrémités planes, le résonateur diélectrique a une forme cylindrique, la première électrode, le résonateur et la seconde électrode sont espacés le long d'un axe de symétrie et sont noyés dans un barreau cylindrique en matériau diélectrique. Il a été constaté que la mise en oeuvre d'une seconde électrode tronconique améliore la sensibilité de l'antenne dans le domaine des fréquences situées entre 0,5 et 1GHz, et que le dimensionnement du résonateur a une influence prépondérante sur la sensibilité aux fréquences situées entre 0,2 et 0,5GHz. De manière analogue, différents essais et simulations ont montré que le choix d'un matériau ayant une permittivité diélectrique relative comprise entre 1 et 3 pour le résonateur, et d'un matériau pour noyer l'antenne ayant une permittivité diélectrique relative comprise entre 3 et 5 donnent lieu à des performances optimales.

Avantageusement, le capteur selon l'invention peut être réalisé avec une première électrode en cuivre, une seconde électrode en aluminium, et un résonateur en polytétrafluoréthylène, le tout étant noyé dans un barreau de résine époxy, ce qui permet de la fabriquer pour un coût très faible.

L'invention sera maintenant décrite plus en détail, et en référence aux dessins annexés qui en illustrent une forme de réalisation à titre d'exemple non limitatif.
La figure 1 est une vue en coupe d'une vanne de vidange durant l'insertion du capteur selon l'invention ;
La figure 2 est une vue en coupe d'une vanne de vidange lorsque le capteur selon l'invention est en position dans celle-ci ;
La figure 3 est une vue en coupe du capteur selon l'invention seul ;
La figure 4 est une représentation graphique de la fonction de transfert du capteur selon l'invention ;
La figure 5 est une représentation graphique de la fonction de transfert d'un capteur de l'art antérieur.

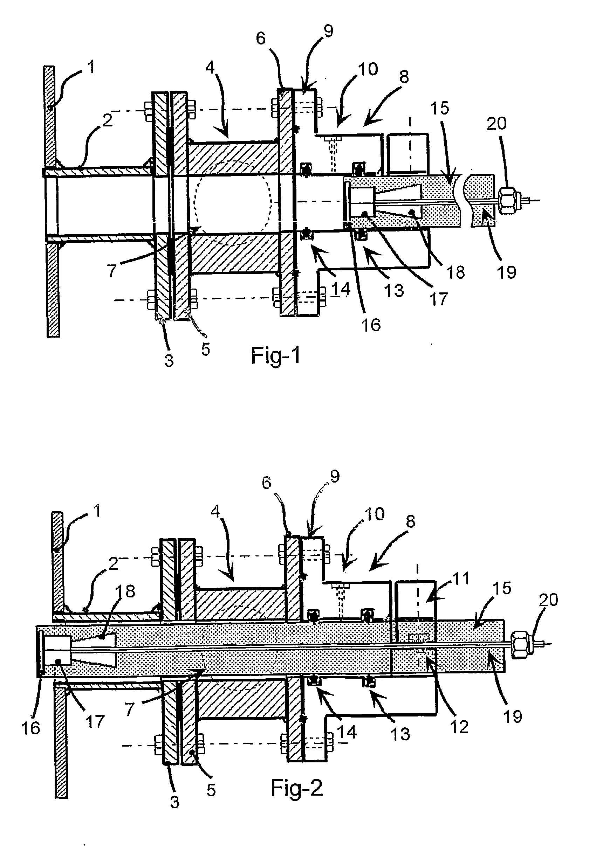

Les figures 1 et 2 montrent une cuve 1 de transformateur contenant de l'huile non représentée, cette cuve 1 comprenant un canal 2 soudé à sa paroi externe, ce canal supportant un flasque 3 auquel est fixée une vanne de vidange 4. Cette vanne 4 comprend deux flasques 5 et 6 soudés à chacune de ses extrémités, le flasque 5 étant raccordé de façon étanche au flasque 3 du canal 2 en étant fixé par des boulons périphériques. La vanne 4 comprend dans cet exemple un obturateur à boule 7 qui est représenté en traits pointillés. Une telle vanne de vidange est généralement prévue en partie basse des cuves de transformateurs à bain d'huile pour permettre d'en retirer l'huile lorsque celle-ci doit être changée, ou bien lorsque le transformateur doit être testé. Une douille 8 de forme globalement cylindrique est située dans le prolongement de la vanne 4 et inclut un flasque 9 à l'une de ses extrémités. Ce flasque est raccordé au flasque 6 de la vanne 4 par plusieurs boulons périphériques traversant chacun les flasques 6 et 9.

L'ensemble constitué du canal 2, de la vanne 4 et de la douille 8 définit ainsi un alésage interne ayant un certain diamètre, par exemple sensiblement égal à 40mm, et pouvant recevoir un capteur 15 selon l'invention qui a une forme générale cylindrique de diamètre externe légèrement inférieur au diamètre interne de cet alésage. La douille 8 comprend encore un évent 10 vertical pouvant être fermé par une vis, deux joints toriques 13 et 14 espacés l'un de l'autre, situés à la périphérie interne de l'alésage et destinés à assurer l'étanchéité entre le capteur 15 et l'alésage interne. Un collier 11 réalisé dans le corps de la douille 8 et associé à un boulon 12 est situé à l'extrémité libre de la douille 8, de manière à permettre la fixation par serrage du capteur selon l'invention dans la douille 8.

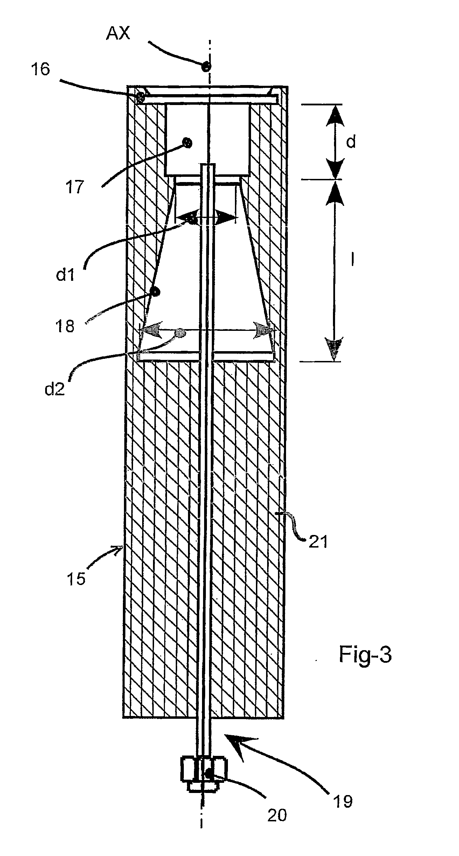

Le capteur 15 qui est représenté en coupe figure 3 a une forme externe cylindrique s'étendant le long d'un axe de symétrie AX. Selon l'invention, ce capteur comprend une antenne constituée d'une première électrode 16 située en extrémité du capteur, et une seconde électrode 18 espacée de la première électrode le long de l'axe AX, et séparée de celle-ci par une pièce 17 en matériau diélectrique qui forme un résonateur. Il a été constaté que la mise en oeuvre d'un tel résonateur améliore significativement la sensibilité de l'antenne pour une gamme de fréquence d'intérêt donnée. Plus particulièrement, la présence de celui-ci permet de réduire significativement les dimensions de l'antenne par rapport aux conceptions classiques, tout en conservant une sensibilité satisfaisante.

Dans une antenne classique, c'est à dire non équipée d'un résonateur entre ses deux électrodes, les lois de la physique imposent que la taille T qui correspond sensiblement à la plus grande dimension d'antenne, est liée à sa fréquence de sensibilité f par la relation T = 142 / f où f est la fréquence en MHz et T la taille en millimètres. Lorsque cette condition n'est pas respectée, la fonction de transfert de l'antenne est significativement détériorée. En conséquence, une antenne classique sensible dans une gamme de fréquences comprise entre 0,2 et 1GHz, doit avoir une taille T située autour de 742mm. Avec une antenne en spirale telle qu'utilisée dans la réalisation décrite par le document de brevet US 6323655, cette condition impliquerait que le diamètre de l'antenne soit de l'ordre de cette taille. Ceci est incompatible avec les diamètres les plus répandus pour les vannes de vidange équipant des cuves de transformateurs.

Mais selon l'invention, l'interposition d'un résonateur entre les deux électrodes 16 et 18 permet de réduire significativement la distance qui les sépare ou de réduire le diamètre de l'antenne, selon le type d'antenne classique pris en comparaison, tout en conservant une sensibilité satisfaisante dans la gamme des fréquences d'intérêt. Ainsi, l'antenne du capteur 15 selon l'invention peut avoir un diamètre valant sensiblement 40 mm tout en présentant une sensibilité satisfaisante dans les fréquences situées entre 0,2 et 1GHz, ce qui sera détaillé plus bas.

Dans un mode de réalisation préféré, la première électrode 16 a une forme de disque et est située à l'une des extrémités du capteur, la seconde électrode 18 a une forme tronconique avec des extrémités planes. Ces deux électrodes sont espacées l'une de l'autre le long de l'axe AX, la seconde électrode 18 en forme de tronc de cône étant disposée de telle sorte que sa base de faible diamètre fait face à la première électrode 16 et que sa base de grand diamètre est la plus éloignée de la première électrode 16 le long de l'axe AX.

La première électrode 16 est ici un disque ayant par exemple une épaisseur de 0,25 mm et un diamètre de 36 mm pour une vanne d'alésage égal à 40mm, dont la face libre affleure en extrémité de capteur. Il faut noter que d'une manière générale, la fonction de transfert de l'antenne diminue à mesure que l'épaisseur du disque de l'électrode 16 augmente. On a pu constater que cette diminution devient importante au delà de 5 mm d'épaisseur, alors qu'elle reste acceptable entre 0,25 mm et 5 mm. Pour concilier une hauteur satisfaisante de la fonction de transfert avec une tenue mécanique suffisante du disque de l'électrode 16, il est préférable que l'épaisseur du disque soit comprise entre 0,25 mm et 5 mm.

Cette première électrode 16 est réalisée en cuivre dans cet exemple, mais d'autres matériaux pourraient également être utilisés pour sa réalisation.

La seconde électrode 18 qui a la forme d'un tronc de cône avec deux extrémités planes est réalisée en aluminium pour que sa permittivité diélectrique soit élevée, des essais ayant montrée que cette permittivité a un rôle important dans la sensibilité du capteur aux ondes électromagnétiques. Le grand diamètre de cette électrode tronconique est proche du diamètre de la première électrode 16 en forme de disque. Dans l'exemple des figures, ce cône est creux en étant réalisé à partir d'un tronc de cône creux aux extrémités duquel ont été rapportés deux disques également en aluminium.

Cette électrode peut aussi être réalisée sous la forme d'un tronc de cône plein, ce qui ne nuit pas aux performances du capteur. Les diamètres et la longueur de cette seconde électrode 18 tronconiques sont choisis pour optimiser la sensibilité de l'antenne, ce qui sera précisé plus bas.

Ces électrodes sont séparées le long de l'axe AX par un résonateur 17 en matériau diélectrique, qui améliore significativement la sensibilité de l'antenne dans le domaine des ultra-hautes fréquences. Ce résonateur 17 est une pièce cylindrique disposée coaxialement à l'axe AX, réalisée dans un matériau dont la permittivité diélectrique est choisie pour maximiser la sensibilité de l'antenne dans la gamme des fréquences comprises entre 0,2 et 0,5GHz. Ce résonateur cylindrique a dans cet exemple un diamètre qui est compris entre le petit diamètre d1 et le grand diamètre d2 de l'électrode conique 18.

Des essais et simulations ont mis en évidence l'influence des dimensions et du positionnement relatif des constituants du capteur sur sa fonction de transfert.

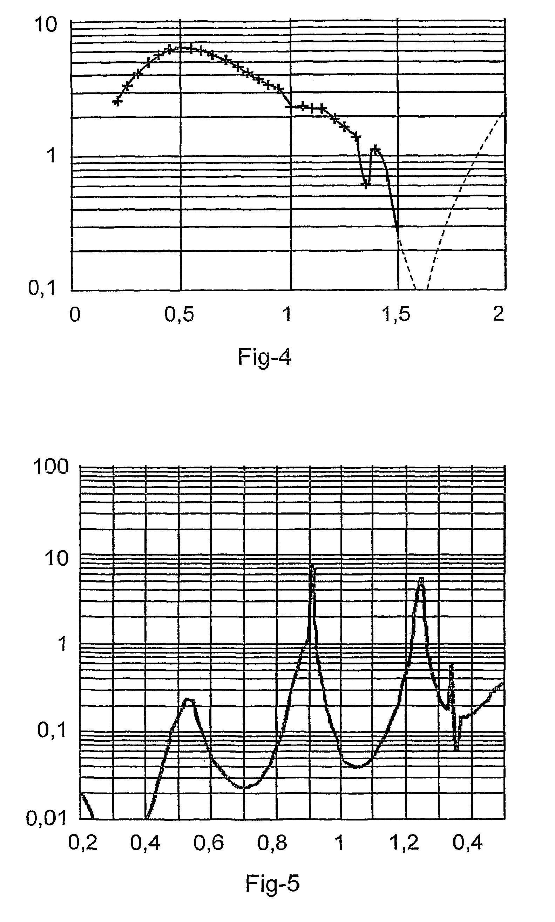

La longueur 1 de l'électrode conique le long de l'axe AX conditionne la fréquence à laquelle la fonction de transfert admet un minimum de hauteur nulle. Plus particulièrement, la fréquence à laquelle apparaît ce minimum est d'autant plus élevée que la longueur 1 est faible. De façon générale, la longueur 1 doit être comprise entre 20 et 150 mm en étant préférablement située entre 30 et 100 mm. Dans l'exemple de réalisation illustré sur les figures, la longueur 1 vaut 40 mm ce qui place le minimum de la fonction de transfert au delà de 1,5GHz, ce qui est représenté en pointillés figure 4,afin de former une fonction de transfert satisfaisante dans toute la gamme des fréquences comprises entre 200MHz et 1,5GHz.

La distance d entre la première électrode en forme de disque et l'électrode conique, qui correspond sensiblement à l'épaisseur du résonateur influe sur la fréquence pour laquelle la fonction de transfert admet un maximum local. Plus cette distance d est élevée plus la fréquence du maximum de la fonction de transfert est basse. Lorsque celle-ci est située entre 10 et 60 mm la fréquence maximale apparaît entre 0,3 et 0,6GHz. Dans l'exemple représenté sur les figures, cette distance vaut 25 mm de sorte que la fréquence du maximum de la fonction de transfert est située autour de 0,5GHz.

Le rapport du grand diamètre d2 sur le petit diamètre d1 influe sur la valeur moyenne de la fonction de transfert pour l'ensemble de la gamme de fréquences d'intérêt et sur la fréquence à laquelle la fonction de transfert admet un maximum. Qualitativement, plus ce rapport est faible -c'est à dire plus d1 est grand- plus la valeur moyenne et la fréquence du maximum sont élevées. Ce rapport sera avantageusement choisi entre 2,5 et 4,5 pour obtenir une hauteur moyenne de la fonction de transfert comprise entre 3,5 et 4 mm.

De manière analogue, le choix des matériaux constitutifs du résonateur et de la résine époxy dans laquelle sont moulés les éléments de l'antenne jouent un rôle dans la qualité de la fonction de transfert du capteur. Dans l'exemple des figures, le matériau choisi pour le résonateur est du polytétrafluoréthylène présentant une permittivité diélectrique relative très faible, située autour de 2. La résine époxy présente une permittivité diélectrique relative valant 4. Plus généralement, des essais montrent qu'une valeur comprise entre 1 et 3 pour le résonateur avec une valeur comprise entre 3 et 5 pour la résine époxy conduisent à une fonction de transfert exploitable pour la gamme de fréquence d'intérêt.

Ces deux électrodes 16 et 18 sont reliées à des appareils de mesure situés hors du capteur 15 par l'intermédiaire d'un câble coaxial 19, terminé extérieurement par un raccord 20, qui traverse le capteur en étant disposé sensiblement le long de son axe de symétrie AX. Le conducteur intérieur du câble coaxial est connecté à l'électrode 16 et la gaine extérieure conductrice du câble coaxial est connectée à l'électrode 18. L'ensemble constitué par les électrodes 16 et 18 et le résonateur 17 est moulé dans un barreau cylindrique 21 en un matériau diélectrique qui n'interfère pas avec la fonction de transfert de l'antenne dans la gamme des fréquences d'intérêt. Avantageusement, cet ensemble peut être moulé dans un barreau 21 de résine époxy pour être fabriqué à moindre coût.

La figure 4 fait apparaître la fonction de transfert du capteur 15 selon l'invention. Elle est donnée sous la forme d'une hauteur en millimètres en fonction de la fréquence en GHz du champ électrique mesuré. Cette hauteur correspond au rapport entre la tension en Volt mesurée en sortie du capteur et l'amplitude en Volt/mètre du champ électrique correspondant. Comme visible dans cette figure, la fonction de transfert est supérieure à 2mm dans la gamme des fréquences comprises entre 0,2 et 1GHz, sa valeur moyenne étant de 4,6mm. D'autre part, cette fonction de transfert est très régulière dans cette gamme de fréquences ; elle ne présente pas de pics particuliers. A titre de comparaison, la figure 5 montre la fonction de transfert du capteur divulgué dans le document de brevet US 6323655. Cette autre fonction de transfert est inférieure à zéro pour les fréquences comprises entre 0,2 et 0,85GHz, et elle présente plusieurs pics de résonance dont un atteint 10mm pour la valeur de 0,9GHz. Cette fonction de transfert comporte une multitude d'autres pics de résonance, de sorte que le capteur n'est pas exploitable dans la gamme de fréquences d'intérêt.

L'installation du capteur dans la vanne de vidange est détaillée ci-dessous. La douille 9 est d'abord raccordée au flasque 6 en y étant fixée par des boulons. Le collier 11 et la vis 12 ne sont pas serrés à ce stade, et la vanne de vidange est fermée. Le capteur 15 contenant l'antenne est inséré dans l'extrémité libre de la douille 8 jusqu'à ce que sa première extrémité se trouve au niveau du joint torique 13. La vanne de vidange 4 est alors ouverte, et l'évent 10 est ouvert pour libérer de l'air emprisonné dans la douille ainsi qu'éventuellement une faible quantité d'huile. L'évent 10 est ensuite refermé en revissant la vis correspondante dans son logement. La vanne de vidange est ensuite complètement ouverte pour permettre le passage du capteur 15. Le capteur est alors enfoncé de manière à traverser le joint torique 14, jusqu'à ce que l'extrémité de ce capteur qui contient l'antenne atteigne l'intérieur de la cuve 1 de manière à coïncider avec la surface interne de celle-ci.

L'extrémité du capteur 15 peut avantageusement pénétrer légèrement à l'intérieur de la surface interne de la cuve 1 pour améliorer encore la fonction de transfert. La profondeur de pénétration est fonction de la position de la vanne de vidange par rapport à la cuve 1, et de la structure du transformateur. Il a notamment été constaté qu'une pénétration de dix millimètres est satisfaisante lorsque la vanne de vidange est à proximité de la terre du bobinage interne. Lorsque la position adéquate est atteinte, le collier 11 est serré sur le capteur au moyen de la vis 12 de manière à assurer une position stable du capteur par rapport à la vanne de vidange. Après la réalisation d'une campagne de mesure, le capteur 15 est retiré de la vanne de vidange selon un ordre inverse à celui indiqué ci-dessus.

La relative compacité d'un capteur selon l'invention présente un intérêt non seulement pour une installation dans une vanne de vidange d'un liquide diélectrique, mais aussi pour une installation dans l'enveloppe métallique d'un appareillage électrique blindé isolé au gaz.

## Revendications

1. Capteur (15) pour détecter des décharges partielles dans une cuve (1) d'appareillage électrique remplie d'un fluide diélectrique, comprenant une antenne (16-18) sensible aux ondes électromagnétiques générées par ces décharges partielles, **caractérisé en ce que** cette antenne est formée par deux électrodes (16, 18) séparées par un résonateur diélectrique (17).

2. Capteur (15) selon la revendication 1, dans lequel la première électrode (16) a une forme de disque, dans lequel la seconde électrode (18) a une forme de tronc de cône à extrémités planes, dans lequel le résonateur diélectrique (17) a une forme cylindrique, la première électrode (16), le résonateur (17) et la seconde électrode (18) étant espacés le long d'un axe de symétrie (AX) et étant noyés dans un barreau cylindrique en matériau diélectrique.

3. Capteur (15) selon la revendication 2, ayant un câble coaxial (19) ayant un conducteur interne connecté à la première électrode (16), et une gaine extérieure conductrice connectée à la seconde électrode (18).

4. Capteur (15) selon la revendication 2 ou 3, dans lequel la première électrode (16) et la seconde électrode (18) sont séparées le long de l'axe (AX) par une distance (d) comprise entre 10 et 60 millimètres.

5. Capteur (15) selon la revendication 2 ou 4, dans lequel les extrémités de la seconde électrode (18) ont respectivement un petit diamètre (d1) et un grand diamètre (d2) dont le rapport est compris entre 2,5 et 4,5 et sont espacées d'une longueur (I) comprise entre 30 et 100 mm.

6. Capteur (15) selon l'une des revendications 2 à 5, dans lequel le résonateur (17) de forme cylindrique a un diamètre compris entre le petit diamètre (d1) et le grand diamètre (d2) des extrémités de l'électrode conique.

7. Capteur (15) selon l'une des revendications 2 à 6, dans lequel le résonateur (17) est réalisé dans un matériau ayant une permittivité diélectrique relative comprise entre 1 et 3.

8. Capteur (15) selon l'une des revendications 2 à 7, dans lequel le barreau cylindrique est réalisé dans un matériau ayant une permittivité diélectrique relative comprise entre 3 et 5.

9. Capteur (15) selon l'une des revendications 2 à 8, dans lequel la première électrode (16) est en cuivre, la seconde électrode (18) est en aluminium, le résonateur (17) est en polytétrafluoréthylène, et dans lequel le tout est noyé dans un barreau de résine époxy.

## Claims

1. A sensor (15) for detecting partial discharges in an electrical equipment tank (1) filled with a dielectric fluid, the sensor comprising an antenna (16, 18) sensitive to the electromagnetic waves generated by such partial discharges, and being **characterized in that** said antenna is formed by two electrodes separated by a dielectric resonator (17).

2. A sensor (15) according to claim 1, in which the first electrode (16) is in the form of a disk, in which the second electrode (18) is in the form of a truncated cone having plane ends, and in which the dielectric resonator (17) is in the form of a cylinder, the first electrode (16), the resonator (17), and the second electrode (18) being spaced apart along an axis of symmetry (AX) and being embedded in a cylindrical bar of dielectric material.

3. A sensor (15) according to claim 2, having a coaxial cable (19) with an inner conductor connected to the first electrode (16) and an outer conductive shield connected to the second electrode (18).

4. A sensor (15) according to claim 2 or claim 3, in which the first electrode (16) and the second electrode (18) are spaced apart along the axis (AX) by a distance (d) lying in the range 10 mm to 60 mm.

5. A sensor (15) according to claim 2 or claim 4, in which the ends of the second electrode (18) have respectively a smaller diameter (d1) and a larger diameter (d2) in a ratio lying in the range 2.5 to 4.5, and spaced apart by a length (I) lying in the range 30 mm to 100 mm.

6. A sensor (15) according to any one of claims 2 to 5, in which the resonator (17) of cylindrical shape has a diameter lying between the smaller diameter (d1) and the larger diameter (d2) of the ends of the conical electrode.

7. A sensor (15) according to any one of claims 2 to 6, in which the resonator (17) is made of a material having relative dielectric permittivity lying in the range 1 to 3.

8. A sensor (15) according to any one of claims 2 to 7, in which the cylindrical bar is made of a material having relative dielectric permittivity lying in the range 3 to 5.

9. A sensor (15) according to any one of claims 2 to 8, in which the first electrode (16) is made of copper, the second electrode (18) is made of aluminum, the resonator (17) is made of polytetrafluoroethylene, and all three are embedded in a bar made of epoxy resin.

## Patentansprüche

1. Sensor zur Detektion von Teilentladungen in einem mit einem dielektrischen Fluid gefüllten Gehäuse (1) eines elektrischen Geräts, der eine Antenne (16-18) umfasst, die empfindlich ist für die durch diese Teilentladungen erzeugten elektromagnetischen Wellen,
**dadurch gekennzeichnet, dass** diese Antenne durch zwei Elektroden (16, 18) gebildet wird, getrennt durch einen dielektrischen Resonator (17).

2. Sensor (15) nach Anspruch 1, bei dem die erste Elektrode (16) die Form einer Scheibe hat, bei dem die zweite Elektrode (18) die Form eines Kegelstumpfes mit ebenen Enden hat, bei dem der Resonator (17) zylinderförmig ist, die erste Elektrode (16), der Resonator (17) und die zweite Elektrode (18) längs einer Symmetrieachse (AX) beabstandet sind und eingebettet sind in einen zylindrischen Stab aus dielektrischem Material.

3. Sensor (15) nach Anspruch 2 mit einem Koaxialkabel (19), das einen mit der ersten Elektrode (16) verbundenen Innenleiter und eine mit der zweiten Elektrode (18) verbundene leitfähige Außenhülle (18) umfasst.

4. Sensor (15) nach Anspruch 2 oder 3, bei dem die erste Elektrode (16) und die zweite Elektrode (18) längs der Achse (AX) durch einen zwischen 10 und 60 Millimeter enthaltenen Abstand (d) getrennt sind.

5. Sensor (15) nach Anspruch 2 oder 4, bei dem die Enden der zweiten Elektrode (18) jeweils einen kleinen Durchmesser (d1) und einen großen Durchmesser (d2) aufweisen, deren Größenverhältnis zwischen 2,5 und 4,5 enthalten ist und die durch eine zwischen 30 und 100 mm enthaltene Länge (I) voneinander beabstandet sind.

6. Sensor (15) nach einem der Ansprüche 2 bis 5, bei dem der zylinderförmige Resonator (17) einen Durchmesser hat, der enthalten ist zwischen dem kleinen Durchmesser (d1) und dem großen Durchmesser (d2) der Enden der konischen Elektrode.

7. Sensor (15) nach einem der Ansprüche 2 bis 6, bei dem der Resonator (17) aus einem Material mit einer zwischen 1 und 3 enthaltenen relativen dielektrischen Permittivität ist.

8. Sensor (15) nach einem der Ansprüche 2 bis 7, bei dem der zylindrische Stab aus einem Material mit einer zwischen 3 und 5 enthaltenen relativen dielektrischen Permittivität ist.

9. Sensor (15) nach einem der Ansprüche 2 bis 8, bei dem die erste Elektrode (16) aus Kupfer ist, die zweite Elektrode (18) aus Aluminium ist, der Resonator (17) aus Polytetrafluorethylen ist, und bei dem das Ganze in einen Epoxydharzstab eingebettet ist.
